# FASCICULE DE BREVET EUROPEEN

(11) **EP 4 291 907 B1**
(45) Date de publication et mention de la délivrance du brevet: **25.12.2024**
(21) Numéro de dépôt: 22703012.9
(22) Date de dépôt: 04.01.2022
(51) Int. Cl.: G01R 27/18, G01R 31/00, G01R 31/52

(54) **PROCEDE D'AUTORISATION OU DE REFUS DE MESURE D'UN DEFAUT D'ISOLATION D'UNE BATTERIE**
VERFAHREN ZUR AUTORISIERUNG ODER UNTERDRÜCKUNG DER MESSUNG EINES BATTERIEISOLATIONSFEHLERS
METHOD FOR AUTHORISING OR REJECTING MEASUREMENT OF A BATTERY INSULATION FAULT

(30) Priorité: 09.02.2021 FR 2101205
(43) Date de publication de la demande: 20.12.2023
(73) Titulaire: Stellantis Auto SAS, 78300 Poissy (FR)
(72) Inventeur: VIOLLIN, Pierre-Mikael, 78000 Versailles (FR); MIZWICKI, Eric, 95180 Menucourt (FR)
(74) Mandataire: PSIP
(86) Numéro de dépôt international: PCT/FR2022/050010
(87) Numéro de publication internationale: WO 2022/171936

(56) Documents cités:
- WO-A1-2020/116133
- CN-A- 105 738 701
- CN-A- 110 174 625
- US-A1- 2017 108 544

## Description

La présente invention revendique la priorité de la demande française N°2101205 déposée le 09.02.2021.

Un aspect de l'invention se rapporte à un procédé d'autorisation ou de refus de mesure d'un défaut d'isolation d'une batterie de stockage d'énergie électrique pour véhicule, notamment électrique ou hybride. Plus particulièrement, l'invention se rapporte au domaine des batteries de traction embarquées sur des véhicules automobiles. Un autre aspect de l'invention porte sur un dispositif construit et agencé pour mettre en oeuvre le procédé.

Le développement actuel des véhicules à traction électrique impose des contraintes de plus en plus importantes aux batteries de stockage d'énergie électrique embarquée.

Une telle batterie est notamment isolée électriquement de la masse du véhicule. Afin de prévenir tout risque d'électrocution, les véhicules embarquant ce type de batterie sont équipés de système de détection de défaut d'isolation. Il est par exemple connu du document FR-A1-3072501 un procédé de détection de défaut d'isolation d'une batterie de traction. Plus particulièrement, le système de contrôle de batterie d'accumulateurs (plus connu sous l'acronyme BMS pour Battery Management System en anglais) estime la bonne isolation via des ponts diviseurs de tension. Pour ce faire, le procédé connecte de manière alternée un premier pont diviseur de tension entre la borne positive d'une batterie haute tension et la masse du véhicule, puis un deuxième pont diviseur de tension entre la borne négative de la batterie haute tension et la masse du véhicule.

Dans le cadre de la détermination de la résistance d'isolement, le document WO 2020/116133 A1 reconnaît déjà que les fluctuations de tension influencent négativement la détermination d'un défaut d'isolation. Pour éviter ce problème, ce document enseigne l'utilisation d'une moyenne mobile des tensions afin de supprimer l'influence des fluctuations.

A chaque connexion, le procédé mesure la tension aux bornes du pont diviseur de tension correspondant et en déduit la valeur de résistance équivalente correspondant à la résistance de fuite entre la partie haute tension et le châssis du véhicule.

Dans cette mise en oeuvre, les tensions mesurées sur les ponts diviseurs de tension sont dépendantes l'une de l'autre et sont en outre dépendantes de la tension batterie.

Seulement, la tension batterie fluctue suivant la charge et la décharge de celle-ci. Cette différence de tension batterie entre deux mesures de tensions aux bornes des ponts diviseurs est susceptible de fausser les estimations de défaut d'isolation et générer à tort la détection d'un défaut d'isolation ou au contraire ne pas détecter un tel défaut.

Le but de l'invention est de pallier les inconvénients de l'art antérieur en proposant un procédé d'autorisation ou de refus de mesure d'un défaut d'isolation d'une batterie de stockage d'énergie électrique pour véhicule permettant d'augmenter la fiabilité de détection d'un défaut d'isolation d'une telle batterie.

Dans ce contexte, l'invention se rapporte ainsi, dans son acceptation la plus large, à un procédé d'autorisation ou de refus de mesure d'un défaut d'isolation d'une batterie de stockage d'énergie électrique pour véhicule, le procédé comportant les étapes de :
- décharger une première fois une capacité d'un groupe motopropulseur,
- lorsque la capacité est déchargée une première fois:
   - mesurer une première tension batterie entre une première borne et une deuxième borne de la batterie,
   - mesurer une première tension de fuite entre la première borne et une masse du véhicule,
- décharger une deuxième fois la capacité,
- lorsque la capacité est déchargée une deuxième fois :
   - mesurer une deuxième tension batterie entre la première borne et la deuxième borne,
   - mesurer une deuxième tension de fuite entre la deuxième borne et la masse du véhicule,
- déterminer un écart de tension batterie entre la première tension batterie mesurée et la deuxième tension batterie mesurée,
- fonction de la première tension de fuite mesurée, de la deuxième tension de fuite mesurée, et de l'écart de tension batterie déterminé, autoriser ou refuser une détection de défaut d'isolation.

Il convient de noter que les valeurs des tensions de fuite mesurées dépendent de la tension batterie. Par exemple, lors d'une phase de recharge de la batterie, la tension interne de celle-ci peut augmenter brutalement, par exemple 30V en 1 seconde. Ainsi, le procédé surveille les fluctuations de tension batterie et les valeurs de tension de fuite mesurées afin d'autoriser ou refuser la détection d'un défaut d'isolation. En effet, plus les valeurs des tensions de fuites mesurées sont faibles et plus la fluctuation de la tension batterie impacte ces valeurs et risque de fausser la détection d'un défaut d'isolation batterie.

Outre les caractéristiques qui viennent d'être évoquées dans le paragraphe précédent, le procédé d'autorisation ou de refus de mesure d'un défaut d'isolation peut présenter une ou plusieurs caractéristiques complémentaires parmi les suivantes, considérées individuellement ou selon toutes les combinaisons techniquement possibles.

Selon un aspect de l'invention, le procédé comporte une étape de prédéterminer une pluralité d'écarts de tension batterie, chaque écart de tension batterie prédéterminé étant associé à une première tension de fuite seuil prédéterminée et à une deuxième tension de fuite seuil prédéterminée.

Selon un aspect de l'invention, une détection de défaut d'isolation est autorisée lorsque pour un écart de tension batterie déterminé égal à un écart de tension batterie prédéterminé,
- la première tension de fuite mesurée est inférieure à une première tension de fuite seuil prédéterminée associée audit écart de tension batterie prédéterminé, et
- la deuxième tension de fuite mesurée est supérieure à une deuxième tension de fuite seuil prédéterminée associée audit écart de tension prédéterminé.

Selon un aspect de l'invention,
- l'étape de décharger une première fois la capacité du groupe motopropulseur comporte les sous-étapes de :
   - connecter une troisième résistance entre la première borne et la masse,
   - décompter une période de décharge,
- l'étape de décharger une deuxième fois la capacité du groupe motopropulseur comporte les sous étapes de :
   - connecter une quatrième résistance entre la deuxième borne et la masse, et
   - décompter une période de décharge.

Selon un aspect de l'invention,
- l'étape de mesurer une première tension de fuite entre la première borne et la masse du véhicule est réalisée aux bornes de la troisième résistance,
- l'étape de mesurer une deuxième tension de fuite entre la deuxième borne et la masse du véhicule est réalisée aux bornes de la quatrième résistance.

Selon un aspect de l'invention, la période de décharge décomptée est comprise entre 2s et 10s.

Selon un aspect de l'invention, la période de décharge décomptée est de 2.5s.

Selon un aspect de l'invention,
- la troisième résistance est connectée en activant un premier commutateur,
- la quatrième résistance est connectée en activant un deuxième commutateur.

Selon un aspect de l'invention, la troisième résistance et la quatrième résistance sont connectées séparément, autrement dit lorsque la troisième ou la quatrième résistance est connectée l'autre est déconnectée..

Un autre aspect de l'invention se rapporte à un dispositif d'autorisation ou de refus de mesure d'un défaut d'isolation d'une batterie de stockage d'énergie électrique pour véhicule, le dispositif étant construit et agencé pour mettre en oeuvre les étapes du procédé selon l'un quelconque des aspects de l'invention précités.

Selon un aspect de l'invention, le dispositif est formé par un système de contrôle de batteries d'accumulateurs.

L'invention et ses différentes applications seront mieux comprises à la lecture de la description qui suit et à l'examen des figures qui l'accompagnent.
[Fig. 1] illustre de façon schématique un procédé d'autorisation ou de refus de mesure d'un défaut d'isolation d'une batterie de stockage d'énergie électrique pour véhicule conforme à un aspect de l'invention.
[Fig. 2] représente de façon schématique un circuit électrique de connexion temporaire d'une batterie de stockage d'énergie électrique pour véhicule avec une masse d'un véhicule aux fins de la mise en oeuvre du procédé selon un aspect de l'invention.
[Fig. 3] illustre de façon schématique un dispositif d'autorisation ou de refus de mesure d'un défaut d'isolation d'une batterie de stockage d'énergie électrique pour véhicule.

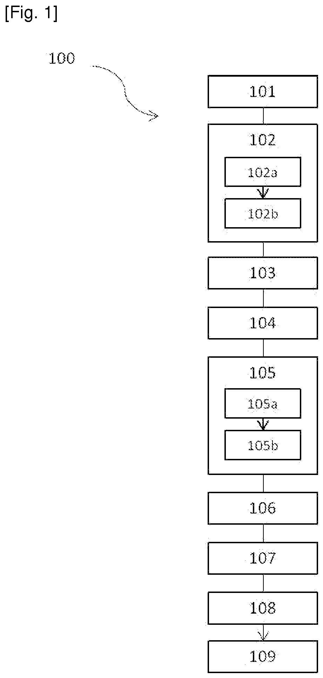

La figure 1 illustre un procédé 100 d'autorisation ou de refus de mesure d'un défaut d'isolation d'une batterie de stockage d'énergie électrique pour véhicule conforme à un aspect de l'invention.

Dans une mise en oeuvre non limitative, le procédé 100 est mis en oeuvre par un système de contrôle de batteries d'accumulateurs, plus connu sous l'acronyme BMS pour Battery Management System en anglais.

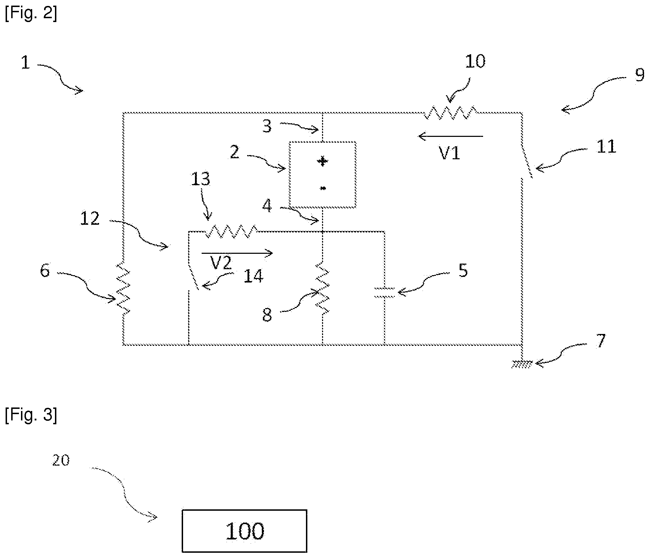

La figure 2 illustre un exemple de réalisation non limitatif d'un circuit électrique 1 de connexion temporaire d'une batterie de stockage d'énergie électrique pour véhicule avec une masse d'un véhicule aux fins de la mise en oeuvre du procédé 100 selon un aspect de l'invention.

Dans cette mise en oeuvre non limitative, le circuit 1 comporte :
- une batterie de stockage d'énergie électrique 2 munie d'une première borne 3 et d'une deuxième borne 4, la batterie 2 peut par exemple être formée par une batterie haute tension de l'ordre de 400V,
- une capacité 5 d'un groupe motopropulseur du véhicule,
- une première résistance 6 du groupe motopropulseur disposée entre la première borne 3 et une masse 7 du véhicule,
- une deuxième résistance 8 du groupe motopropulseur disposée entre la deuxième borne 4 et la masse 7 du véhicule,
- une première connexion 9 entre la première borne 3 et la masse 7 du véhicule, la première connexion 9 comportant une troisième résistance 10 et un premier commutateur 11 construit et agencé pour connecter ou déconnecter la troisième résistance 10, la troisième résistance 10 peut être par exemple de l'ordre de 1 Mégaohms,
- une deuxième connexion 12 entre la deuxième borne 4 et la masse 7 du véhicule, la deuxième connexion 12 comportant une quatrième résistance 13 et un deuxième commutateur 14 construit et agencé pour connecter ou déconnecter la quatrième résistance 13, la quatrième résistance 13 peut être par exemple de l'ordre de 1 Mégaohms.

Le procédé 100 comporte une étape de prédéterminer 101 une pluralité d'écarts de tension batterie, chaque écart de tension batterie prédéterminé étant associé à une première tension de fuite seuil prédéterminée et à une deuxième tension de fuite seuil prédéterminée.

Par exemple, pour un écart de tension prédéterminé de 1V, sont associées :
- une première tension de fuite seuil prédéterminée entre la première borne 3 de la batterie 2 et la masse 7 de 0.1V, et
- une deuxième tension de fuite seuil prédéterminée entre la deuxième borne 4 de la batterie 2 et la masse 7 de 2,9V.

Par exemple, pour un écart de tension prédéterminé de 5V, sont associées :
- une première tension de fuite seuil prédéterminée entre la première borne 3 de la batterie 2 et la masse 7 de 0.5V, et
- une deuxième tension de fuite seuil prédéterminée entre la deuxième borne 4 de la batterie 2 et la masse 7 de 2,5V.

Le procédé 100 comporte en outre une étape de décharger 102 une première fois la capacité 5 du groupe motopropulseur.

L'étape de décharger 102 une première fois la capacité 5 comporte les sous-étapes de :
- connecter 102a la troisième résistance 10 entre la première borne 3 et la masse 7, et
- décompter 102b une période de décharge.

La période de décharge décomptée est typiquement comprise entre 2s et 10s.

En effet, avant de réaliser une mesure de tension aux bornes de la troisième résistance 10, il faut attendre le temps de décharge de cette capacité 5. Cette capacité peut être de 1.5 µF. Ainsi, à titre d'exemple, pour une troisième résistance 10 inférieure à 1 Mégahoms, il est nécessaire d'attente 2,5 s pour décharger la capacité 5.

Lorsque la capacité 5 du groupe motopropulseur est déchargée une première fois, le procédé 100 comporte une étape de mesurer 103 une première tension batterie entre la première borne 3 et la deuxième borne 4 de la batterie 2. Dans cet exemple, la première borne 3 est une borne positive et la deuxième borne 4 est une borne négative.

Lorsque la capacité 5 du groupe motopropulseur est déchargée une première fois, le procédé 100 comporte également une étape de mesurer 104 une première tension de fuite V1 entre la première borne 3 et la masse 7 du véhicule. A cette fin, le système de contrôle des batteries d'accumulateurs mesure la tension aux bornes de la troisième résistance 10 qui est connectée.

Le procédé 100 comporte en outre une étape de décharger 105 une deuxième fois la capacité 5 du groupe motopropulseur.

L'étape de décharger 105 une deuxième fois la capacité 5 du groupe motopropulseur comporte les sous étapes de :
- connecter 105a la quatrième résistance 13 entre la deuxième borne 4 et la masse 7,
- décompter 105b une période de décharge.

La période de décharge décomptée est typiquement comprise entre 2s et 10s, par exemple 2.5s.

Lorsque la capacité 5 est déchargée une deuxième fois, le procédé 100 comporte une étape de mesurer 106 une deuxième tension batterie entre la première borne 3 et la deuxième borne 4 de la batterie 2.

Lorsque la capacité 5 est déchargée une deuxième fois, le procédé 100 comporte également une étape de mesurer 107 une deuxième tension de fuite V2 entre la deuxième borne 4 et la masse 7 du véhicule. A cette fin, le système de contrôle de batteries d'accumulateurs mesure la tension aux bornes de la quatrième résistance 13 qui est connectée.

La capacité 5 du groupe motopropulseur matérialisée par l'ensemble des composants du groupe motopropulseur, comme par exemple le compresseur de climatisation ou encore l'onduleur de puissance, est déchargée avant que les première et deuxième tensions de fuite V1, V2 soient mesurées ainsi que les première et deuxième tensions de batterie. Les valeurs de mesure obtenues ne sont par conséquent aucunement perturbées par les résistances du groupe motopropulseur.

Le procédé 100 comporte en outre une étape 108 de déterminer un écart de tension entre la première tension batterie mesurée et la deuxième tension batterie mesurée.

En effet, durant le temps d'attente des deux décharges de la capacité 5 du groupe motopropulseur, à savoir 5s dans notre exemple, la tension batterie peut être amenée à varier brutalement selon le courant entrant ou sortant dans la batterie 2. Une telle variation de courant impacte alors fortement la précision de la mesure d'isolement, à savoir les mesures des première et deuxième tensions de fuite, respectivement V1, V2.

Le procédé 100 compote également, fonction de la première tension de fuite V1 mesurée, par exemple 0,05V, de la deuxième tension de fuite V2 mesurée, par exemple 3,1V et de l'écart de tension batterie déterminé, par exemple 1V, une étape 109 d'autoriser ou de refuser une détection de défaut d'isolation.

Dans un exemple de réalisation non limitatif, une détection de défaut d'isolation est autorisée lorsque :
- pour un écart de tension batterie déterminé égal à un écart de tension batterie prédéterminé,
- la première tension de fuite V1 mesurée est inférieure à une première tension de fuite seuil prédéterminée associée audit écart de tension batterie prédéterminé, et
- la deuxième tension de fuite V2 mesurée est supérieure à une deuxième tension de fuite seuil prédéterminée associée audit écart de tension prédéterminé.

Par exemple, lors de l'étape de prédéterminer 101 une pluralité d'écarts de tension batterie, un écart de tension batterie de 1V est associé à une première tension de fuite seuil prédéterminée de 0,1V et une deuxième tension de fuite seuil prédéterminée de 2,9V.

Dans ce cas, une détection de défaut d'isolation est autorisée puisque :
- l'écart de tension batterie déterminé de 1V est égal à un écart de tension batterie prédéterminé de 1V,
- la première tension de fuite mesurée de 0,05V est inférieure à la première tension de fuite seuil prédéterminé de 0,1V associée à l'écart de tension batterie prédéterminé de 1V, et
- la deuxième tension de fuite mesurée de 3,1V est supérieure à la deuxième tension de fuite seuil prédéterminée de 2,9V associée à l'écart de tension batterie prédéterminé de 1V.

Selon un autre exemple, si le procédé 100 à permis de :
- mesurer une première tension de fuite V1 de 0,05V,
- mesurer une deuxième tension de fuite V2 de 2,5V, et
- déterminer un écart de tension batterie de 1V,

alors aucune détection de défaut d'isolation n'est autorisée puisque :
- l'écart de tension batterie déterminé de 1V est égal à un écart de tension prédéterminé de 1V,
- la première tension de fuite V1 mesurée de 0,05V est inférieure à la première tension de fuite seuil prédéterminé de 0,1V associée à l'écart de tension batterie prédéterminé de 1V, et
- la deuxième tension de fuite V2 mesurée de 2,5V est inférieure à la deuxième tension de fuite seuil prédéterminée de 2,9V associée à l'écart de tension batterie prédéterminé de 1V.

L'invention permet ainsi de vérifier de manière récurrente que le contrôle du niveau d'isolation électrique de la batterie 2 n'est pas faussé par une fluctuation de la tension batterie.

Il convient de noter que le schéma électrique illustré à la figure 2 est un schéma de principe, étant entendu que sa mise en oeuvre peut impliquer certaines modifications.

La figure 3 illustre de façon schématique un dispositif 20 d'autorisation ou de refus de mesure d'un défaut d'isolation d'une batterie de stockage d'énergie électrique pour véhicule. Le dispositif 20 est construit et agencé pour mettre en oeuvre les étapes du procédé 100 tel que précédemment présenté à l'appui des figures 1 et 2. Ce dispositif 20 peut être formé par un système de contrôle de batteries d'accumulateurs, plus connu sous l'acronyme BMS pour Battery Management System en anglais.

## Revendications

1. Procédé (100) d'autorisation ou de refus de mesure d'un défaut d'isolation d'une batterie de stockage d'énergie électrique pour véhicule, ledit procédé (100) étant **caractérisé en ce qu'**il comporte les étapes de :
- décharger (102) une première fois une capacité (5) d'un groupe motopropulseur,
- lorsque ladite capacité (5) est déchargée une première fois:
∘ mesurer (103) une première tension batterie entre une première borne (3) et une deuxième borne (4) d'une batterie (2),
∘ mesurer (104) une première tension de fuite (V1) entre la première borne (3) et une masse (7) du véhicule,
- décharger (105) une deuxième fois ladite capacité (5),
- lorsque ladite capacité (5) est déchargée une deuxième fois :
∘ mesurer (106) une deuxième tension batterie entre la première borne (3) et la deuxième borne (4),
∘ mesurer (107) une deuxième tension de fuite (V2) entre la deuxième borne (4) et la masse (7) du véhicule,
- déterminer (108) un écart de tension batterie entre ladite première tension batterie mesurée et ladite deuxième tension batterie mesurée,
- fonction de ladite première tension de fuite (V1) mesurée, de ladite deuxième tension de fuite (V2) mesurée, et dudit écart de tension batterie déterminé, autoriser ou refuser (109) une détection de défaut d'isolation.

2. Procédé (100) selon la revendication 1 **caractérisé en ce qu'**il comporte une étape de prédéterminer (101) une pluralité d'écarts de tension batterie, chaque écart de tension batterie prédéterminé étant associé à une première tension de fuite seuil prédéterminée et à une deuxième tension de fuite seuil prédéterminée.

3. Procédé (100) selon la revendication 2 **caractérisé en ce qu'**une détection de défaut d'isolation est autorisée lorsque :
- pour un écart de tension batterie déterminé égal à un écart de tension batterie prédéterminé,
- la première tension de fuite (V1) mesurée est inférieure à une première tension de fuite seuil prédéterminée associée audit écart de tension batterie prédéterminé, et
- la deuxième tension de fuite (V2) mesurée est supérieure à une deuxième tension de fuite seuil prédéterminée associée audit écart de tension prédéterminé.

4. Procédé (100) selon l'une quelconque des revendications précédentes **caractérisé en ce que** :
- l'étape de décharger (102) une première fois le capacité (5) du groupe motopropulseur comporte les sous-étapes de :
∘ connecter (102a) une troisième résistance (10) entre la première borne (3) et la masse (7),
∘ décompter (102b) une période de décharge,
- l'étape de décharger (105) une deuxième fois la capacité (5) du groupe motopropulseur comporte les sous étapes de :
∘ connecter (105a) une quatrième résistance (13) entre la deuxième borne (4) et la masse (7), et
∘ décompter (105b) une période de décharge.

5. Procédé (100) selon la revendication précédente **caractérisé en ce que** :
- l'étape de mesurer (104) une première tension de fuite (V1) entre la première borne (3) et la masse (7) du véhicule est réalisée aux bornes de la troisième résistance (10),
- l'étape de mesurer (107) une deuxième tension de fuite (V2) entre la deuxième borne (4) et la masse (7) du véhicule est réalisée aux bornes de la quatrième résistance (13).

6. Procédé (100) selon la revendication 4 ou 5 **caractérisé en ce que** la période de décharge décomptée est comprise entre 2s et 10s.

7. Procédé (100) selon la revendication précédente **caractérisé en ce que** la période de décharge décomptée est de 2.5s.

8. Procédé (100) selon l'une quelconque des revendications 4 à 7 **caractérisé en ce que** :
- la troisième résistance (10) est connectée en activant un premier commutateur (11),
- la quatrième résistance (13) est connectée en activant un deuxième commutateur (14).

9. Dispositif (20) d'autorisation ou de refus de mesure d'un défaut d'isolation d'une batterie de stockage d'énergie électrique pour véhicule, ledit dispositif (20) étant **caractérisé en ce qu'**il est construit et agencé pour mettre en oeuvre les étapes du procédé (100) selon l'une quelconque des revendications précédentes.

10. Dispositif (20) selon la revendication précédente **caractérisé en ce qu'**il est formé par un système de contrôle de batteries d'accumulateurs.

## Patentansprüche

1. Verfahren (100) zum Genehmigen oder Verweigern der Messung eines Isolationsfehlers einer elektrischen Energiespeicherbatterie für ein Fahrzeug, wobei das Verfahren (100) **dadurch gekennzeichnet ist, dass** es die folgenden Schritte umfasst:
- erstmaliges Entladen (102) einer Kapazität (5) eines Antriebsstrangs,
- wenn die Kapazität (5) zum ersten Mal entladen wird:
o Messen (103) einer ersten Batteriespannung zwischen einem ersten Anschluss (3) und einem zweiten Anschluss (4) einer Batterie (2),
o Messen (104) einer ersten Leckspannung (V1) zwischen dem ersten Anschluss (3) und einer Masse (7) des Fahrzeugs,
- Entladen (105) ein zweites Mal die Kapazität (5),
- wenn die Kapazität (5) ein zweites Mal entladen wird:
o Messen (106) einer zweiten Batteriespannung zwischen dem ersten Anschluss (3) und dem zweiten Anschluss (4),
o Messen (107) einer zweiten Leckspannung (V2) zwischen dem zweiten Anschluss (4) und der Masse (7) des Fahrzeugs,
- Bestimmen (108) einer Batteriespannungsdifferenz zwischen der ersten gemessenen Batteriespannung und der zweiten gemessenen Batteriespannung,
- abhängig von der ersten gemessenen Leckspannung (V1), der zweiten gemessenen Leckspannung (V2) und der ermittelten Batteriespannungsdifferenz die Erkennung von Isolationsfehlern zulässt oder verweigert (109).

2. Verfahren (100) nach Anspruch 1, **dadurch gekennzeichnet, dass** es einen Schritt des Vorbestimmens (101) mehrerer Batteriespannungsabweichungen umfasst, wobei jede vorbestimmte Batteriespannungsabweichung einer ersten vorbestimmten Schwellenleckspannung und einer zweiten vorbestimmten Schwellenleckspannung zugeordnet ist.

3. Verfahren (100) nach Anspruch 2, **dadurch gekennzeichnet, dass** die Erkennung von Isolationsfehlern zulässig ist, wenn:
- für eine ermittelte Batteriespannungsdifferenz gleich einer vorgegebenen Batteriespannungsdifferenz,
- die erste gemessene Leckspannung (V1) ist kleiner als eine erste vorgegebene Schwellenwert-Leckspannung, die der vorgegebenen Batteriespannungsdifferenz zugeordnet ist, und
- die gemessene zweite Leckspannung (V2) größer ist als eine zweite vorgegebene Schwellenwert-Leckspannung, die der vorgegebenen Spannungsdifferenz zugeordnet ist.

4. Verfahren (100) nach einem der vorhergehenden Ansprüche, **dadurch gekennzeichnet, dass**:
- Der Schritt des erstmaligen Entladens (102) der Kapazität (5) des Antriebsstrangs umfasst die Teilschritte:
o schalten (102a),
o Herunterzählen (102b) einer Entladeperiode,
- Der Schritt des zweiten Entladens (105) der Kapazität (5) des Antriebsstrangs umfasst die Unterschritte:
o Verbinden (105a) eines vierten Widerstands (13) zwischen dem zweiten Anschluss (4) und Masse (7), und
o Herunterzählen (105b) einer Entladeperiode.

5. Verfahren (100) nach dem vorhergehenden Anspruch, **dadurch gekennzeichnet, dass**:
- der Schritt des Messens (104) einer ersten Leckspannung (V1) zwischen dem ersten Anschluss (3) und der Masse (7) des Fahrzeugs über den dritten Widerstand (10) durchgeführt wird,
- der Schritt des Messens (107) einer zweiten Leckspannung (V2) zwischen dem zweiten Anschluss (4) und der Masse (7) des Fahrzeugs über den vierten Widerstand (13) durchgeführt wird.

6. Verfahren (100) nach Anspruch 4 oder 5, **dadurch gekennzeichnet, dass** die gezählte Entladeperiode zwischen 2s und 10s beträgt.

7. Verfahren (100) nach dem vorhergehenden Anspruch, **dadurch gekennzeichnet, dass** die gezählte Entladezeit 2,5 s beträgt.

8. Verfahren (100) nach einem der Ansprüche 4 bis 7, **dadurch gekennzeichnet, dass**:
- der dritte Widerstand (10) wird durch Aktivieren eines ersten Schalters (11) zugeschaltet,
- der vierte Widerstand (13) wird durch Aktivierung eines zweiten Schalters (14) zugeschaltet.

9. Vorrichtung (20) zum Genehmigen oder Verweigern der Messung eines Isolationsfehlers einer elektrischen Energiespeicherbatterie für ein Fahrzeug, wobei die Vorrichtung (20) **dadurch gekennzeichnet ist, dass** sie so konstruiert und angeordnet ist, dass sie die Schritte des Verfahrens (100) gemäß durchführt einem der vorstehenden Ansprüche.

10. Vorrichtung (20) nach dem vorhergehenden Anspruch, **dadurch gekennzeichnet, dass** sie durch ein Speicherbatterie-Steuerungssystem gebildet ist.

## Claims

1. Method (100) for authorizing or refusing to measure an insulation fault in an electric energy storage battery for a vehicle, said method (100) being **characterized in that** it comprises the steps of:
- unload (102) a capacity (5) of a powertrain for the first time,
- when said capacity (5) is discharged for the first time:
o measuring (103) a first battery voltage between a first terminal (3) and a second terminal (4) of a battery (2),
o measure (104) a first leakage voltage (V1) between the first terminal (3) and a ground (7) of the vehicle,
- discharge (105) a second time said capacity (5),
- when said capacity (5) is discharged a second time:
o measure (106) a second battery voltage between the first terminal (3) and the second terminal (4),
o measure (107) a second leakage voltage (V2) between the second terminal (4) and the ground (7) of the vehicle,
- determining (108) a battery voltage difference between said first measured battery voltage and said second measured battery voltage,
- depending on said first measured leakage voltage (V1), said second measured leakage voltage (V2), and said determined battery voltage difference, authorize or refuse (109) an insulation fault detection.

2. Method (100) according to claim 1 **characterized in that** it comprises a step of predetermining (101) a plurality of battery voltage differences, each predetermined battery voltage difference being associated with a first predetermined threshold leakage voltage and a second predetermined threshold leakage voltage.

3. Method (100) according to claim 2 **characterized in that** an insulation fault detection is authorized when:
- for a determined battery voltage difference equal to a predetermined battery voltage difference,
- the first measured leakage voltage (V1) is lower than a first predetermined threshold leakage voltage associated with said predetermined battery voltage difference, and
- the second measured leakage voltage (V2) is greater than a second predetermined threshold leakage voltage associated with said predetermined voltage difference.

4. Method (100) according to any one of the preceding claims, **characterized in that**:
- the step of discharging (102) a first time the capacity (5) of the powertrain comprises the sub-steps of:
o connect (102a) a third resistor (10) between the first terminal (3) and ground (7),
o count (102b) a discharge period,
- the step of discharging (105) a second time the capacity (5) of the powertrain comprises the sub-steps of:
o connect (105a) a fourth resistor (13) between the second terminal (4) and ground (7), and
o count (105b) a discharge period.

5. Method (100) according to the preceding claim, **characterized in that**:
- the step of measuring (104) a first leakage voltage (V1) between the first terminal (3) and the ground (7) of the vehicle is carried out at the terminals of the third resistor (10),
- the step of measuring (107) a second leakage voltage (V2) between the second terminal (4) and the ground (7) of the vehicle is carried out at the terminals of the fourth resistor (13).

6. Method (100) according to claim 4 or 5 **characterized in that** the counted discharge period is between 2s and 10s.

7. Method (100) according to the preceding claim, **characterized in that** the counted discharge period is 2.5s.

8. Method (100) according to any one of claims 4 to 7, **characterized in that**:
- the third resistor (10) is connected by activating a first switch (11),
- the fourth resistor (13) is connected by activating a second switch (14).

9. Device (20) for authorizing or refusing to measure an insulation fault in an electric energy storage battery for a vehicle, said device (20) being **characterized in that** it is constructed and arranged to implement the steps of the method (100) according to any one of the preceding claims.

10. Device (20) according to the preceding claim, **characterized in that** it is formed by a battery control system.
